# EUROPÄISCHE PATENTSCHRIFT

(11) **EP 1 183 404 B1**
(45) Veröffentlichungstag und Bekanntmachung des Hinweises auf die Patenterteilung: **22.01.2003**
(21) Anmeldenummer: 00979644.2
(22) Anmeldetag: 30.11.2000
(51) Int. Cl.: C23C 14/50, C23C 14/56, B65G 17/20

(54) **VORRICHTUNG ZUM BESCHICHTEN VON FLASCHEN UND FLASCHEN-TRANSPORTKÖRPER**
DEVICE FOR COATING BOTTLES AND BODIES FOR TRANSPORTING BOTTLES
DISPOSITIF POUR ENDUIRE DES BOUTEILLES ET ELEMENTS DE TRANSPORT DE BOUTEILLES

(30) Priorität: 18.01.2000 DE 10001976
(43) Veröffentlichungstag der Anmeldung: 06.03.2002
(73) Patentinhaber: KRONES AG, 93068 Neutraubling (DE)
(72) Erfinder: KAMPMANN, Lutz, 93073 Neutraubling (DE)
(86) Internationale Anmeldenummer: EP0012008
(87) Internationale Veröffentlichungsnummer: WO01053563

(56) Entgegenhaltungen:
- DE-A- 2 429 222

## Beschreibung

Die Erfindung betrifft eine Vorrichtung gemäß dem Oberbegriff des Anspruchs 1 sowie einen Flaschen-Transportkörper gemäß dem Oberbegriff des nebengeordneten Anspruchs 15.

In der Getränkeindustrie werden in zunehmendem Maß Kunststoffflaschen (vorwiegend aus PET) verwendet. Dem Nachteil der Kunststoffflaschen hinsichtlich einer unvermeidbaren Durchlässigkeit für austretendes Kohlendioxid und eintretenden Luftsauerstoff wird dadurch begegnet, dass die Kunststoffflaschen zum Aufbau einer Barrierewirkung mehrschichtig ausgebildet oder besprüht oder bedampft werden.

Bei einer aus DE 24 29 222 A bekannten Sprühvorrichtung sind an einer zur Förderstrecke der Transportkörper parallelen und getrennten Förderstrecke auf die Transportkörper ausgerichtete Konsolen angebracht, deren jede ein Abdeckelement trägt. Mit stationären Führungsbahnen kooperierende Nockenantriebe schwenken jedes zunächst in einer Passivstellung gehaltenes Abdeckelement gegen einen Flaschenhalter, der nicht ordnungsgemäß mit einer zu besprühenden Flasche bestückt ist. Vor dem Flaschenabgabebereich werden in ihren Abdeckstellungen befindliche Abdeckelemente wieder in die Passivstellung zurückgeschwenkt. Jedes Abdeckelement fungiert als Flaschenabtaster, in dem es bei ordnungsgemäßer Bestückung des zugeordneten Flaschenhalters mit einer Flasche vor der Bewegung in die Abdeckstellung an der Flasche zur Anlage kommt und abgefangen wird, ohne dass der Nockenantrieb die Verstellung in die Abdeckstellung vornehmen kann. Auf diese Weise wird verhindert, dass ein nicht ordnungsgemäß bestückter Flaschenhalter in der Sprühstation besprüht und verschmutzt wird. Der bauliche Mehraufwand für die separate Förderstrecke der Abdeckelemente und deren Bewegungssteuerung ist erheblich. Außerdem sind die Flaschen vertikal hängend durch die Sprühstation zu fördern, um die ordnungsgemäße Kooperation der Transportkörper mit den Abdeckelementen sicherzustellen, was das ordnungsgemäße Besprühen bzw. Beschichten der Flaschen erschwert.

Weiterer Stand der Technik ist enthalten in WO98/40531 (PCT/US98/05293) und DE 198 07 032 A.

Der Erfindung liegt die Aufgabe zugrunde, eine Vorrichtung der eingangs genannten Art und einen für diese Vorrichtung geeigneten Flaschen-Transportkörper anzugeben, die sich durch bauliche Einfachheit und hohe Betriebssicherheit auszeichnen. Teil der Aufgabe ist es ferner, die Flaschen bei Übergabe an die und Abnahme von den Transportkörpern und in der Beschichtungsstation ohne Beeinträchtigung durch die Funktion der Abdeckelemente in jeweils optimalen Positionen orientieren zu können.

Die gestellte Aufgabe wird mit den Merkmalen des Anspruchs 1 und den Merkmalen des nebengeordneten Anspruchs 15 gelöst.

Da in der Vorrichtung jeder Transportkörper eines Flaschenhalters zugleich als Träger und Förderer des Abdeckelementes fungiert, ergibt sich trotz der Sicherheitsfunktion der Abdeckelemente ein erheblich verringerter baulicher Aufwand in der Vorrichtung. Die an den Transportkörpern angeordneten Abdeckelemente sind in jedem Betriebsstadium genau auf die zugeordneten Flaschenhalter ausgerichtet, so dass sie ihre Abdeckfunktion sehr zuverlässig erbringen und den Flaschenhalter oder den Bereich des Flaschenhalters gegen unerwünschte Verschmutzungen durch die Beschichtungssubstanzen schützen können, falls keine Flasche vorhanden ist. Mit der baulichen Vereinfachung geht eine erhebliche Einsparung an Bauraum einher. Die Anbringung der Abdeckelemente an den Transportkörpern bedingt nur geringfügige Modifikationen bewährter Ausbildungskonzepte, so dass auch die Nachrüstung bereits im Betrieb befindlicher Transportkörper mit Abdeckelementen möglich ist.

Der Flaschen-Transportkörper hält mit dem Flaschenhalter die Flasche bei Übergabe bzw. Abnahme und in der Beschichtungsstation in unterschiedlichen, jeweils optimalen Orientierungen. Diese Lageänderungen zwischen den unterschiedlichen Orientierungen nutzt das durch Schwerkraft betätigbare Abdeckelement, um bei Bedarf einen nicht ordnungsgemäß mit einer Flasche bestückten Flaschenhalter in der Beschichtungsstation abzudecken. Der Einsatz der Schwerkraft als Antriebskraft für das Abdeckelement spart aufwendige Antriebssteuereinrichtungen. Das System ist funktionssicher, wartungsarm und kostengünstig. Die Nachrüstung bereits im Einsatz befindlicher Transportkörper mit Abdeckelementen ist jederzeit möglich. An der Förderstrecke und in der Beschichtungsstation sind keine nennenswerten baulichen Veränderungen erforderlich.

Gemäß Anspruch 2 ist der Massenschwerpunkt des Abdeckelements so gegenüber der Schwenk- oder Drehlagerung versetzt, dass die Schwerkraft das Abdeckelement zwischen den Passiv- und Abdeckstellungen bewegen und in der jeweiligen Stellung halten kann. Ein eigener Antrieb für das Abdeckelement ist dadurch entbehrlich.

Zweckmäßigerweise wird gemäß Anspruch 3 die Lageänderung des Transportkörpers bei der Bewegung entlang der Förderstrecke als Antriebsimpuls zum Verstellen des Abdeckelementes genutzt. Ferner wird die Schwerkraft eingesetzt, um das Abdeckelement in der jeweils korrekten Stellung zu halten.

Dabei ist es gemäß Anspruch 4 zweckmäßig, den Transportkörper bei der Flaschenübernahme bzw. -abgabe jeweils in etwa mit vertikalem Flaschenhalter zu orientieren, in der Beschichtungsstation hingegen in etwa horizontal. Die horizontale Lage in der Beschichtungsstation führt bei der üblicherweise durchgeführten Rotationsbewegung der Flasche um ihre Längsachse zu einer vollkommenen Beschichtung der Flaschenoberfläche, während bei der vertikalen Orientierung die Übernahme bzw. Abgabe der Flaschen auf engem Bauraum problemlos möglich ist.

Günstig ist es, wenn der Flaschenhalter an einer Mündungsöffnung des Transportkörpers bewegbar angeordnet ist, und das Abdeckelement ein in oder auf die Mündungsöffnung passendes Verschlussteil besitzt. In der Abdeckstellung wird damit das Eindringen von Beschichtungs- oder Sprühsubstanzen und die Verschmutzung des Flaschenhalters und dessen Umgebung im Transportkörper wirkungsvoll verhindert.

Baulich einfach ist das Abdeckelement als Klappe ausgebildet, die am Transportkörper an einer Seite des Flaschenhalters gelagert und um vorzugsweise mindestens 90° hin- und herschwenkbar ist.

Die Klappe kann eine einfache Blech- oder Kunststoffplatte sein, an der die Schwenkachse mit einer Abflachung befestigt ist, wobei Achsstummel der Schwenkachse in Lagerbohrungen am Transportkörper befestigter Lageböcke gehalten sind. Die Schwenkachse teilt die Klappe in einen Verstellteil und einen Abdeckteil, wobei der Abdeckteil entweder länger oder mit konzentrierter Masse ausgebildet ist, um den Massenschwerpunkt mit möglichst großem Hebelarm von der Schwenkachse zu beabstanden.

Um den Schwenkwiderstand der Klappe möglichst gering zu halten, sollten die Lagerbohrungen und/oder die Achsstummel aus gleitfreudigem Material oder gleitfreudig beschichtet sein. Gegebenenfalls sind sogar die Lagerböcke insgesamt aus gleitfreudigem Kunststoff hergestellt. Die Bewegungsbereiche der Schwenkachse in den Lagerböcken sind zweckmäßigerweise abgeschirmt.

Um die Betriebssicherheit zu erhöhen, kann es zweckmäßig sein, an der Klappe wenigstens ein Ballastgewicht anzuordnen, das den Massenschwerpunkt möglichst weit weg von der Schwenkachse platziert.

Bei der Ausführungsform gemäß Anspruch 10 fungiert die Klappe selbsttätig als Flaschenabtaster, der die Klappe dann in einer für den Angriff der Abdeckelement-Stellvorrichtung korrekten Stellung hält, wenn der Flaschenhalter ordnungsgemäß mit einer Flasche bestückt ist. Die Stellvorrichtung ist durch eine stationäre Führung entlang der Förderstrecke realisiert, die nur bei Anwesenheit einer Flasche am Flaschenhalter am Verstellteil der Klappe angreift und diese in der Passivstellung hält, in der sie die in der Sprühstation rotierende Flasche nicht berührt.

Bei einer alternativen Ausführungsform gemäß Anspruch 11 wird das Abdeckelement durch einen Kraftspeicher zumindest in Richtung zur Abdeckstellung beaufschlagt. Erneut fungiert das Abdeckelement als Flaschenabtaster, indem es bei ordnungsgemäßer Anwesenheit einer Flasche am Flaschenhalter eine Stellung einnimmt, in der die Abdeckelement-Stellvorrichtung mit ihrer stationären Führung am Abdeckelement angreifen kann. Ist hingegen keine Flasche am Flaschenhalter angebracht worden, dann bewegt der Kraftspeicher das Abdeckelement in die Abdeckstellung, so dass die Führung der Stellvorrichtung gar nicht zum Angriff an dem Abdeckelement gelangt. Es liegt auf der Hand, dass vor dem Abnahmebereich der Förderstrecke eine weitere Stellvorrichtung vorgesehen ist, die in ihren Abdeckstellungen befindliche Abdeckelemente für die neuerliche Übernahme von Flaschen wieder in die Passivstellungen zurückbewegt.

Bei einer weiteren alternativen Ausführungsform gemäß Anspruch 12 wird das Abdeckelement in bistabiler Weise sowohl zur Passivstellung als auch zur Abdeckstellung vorgespannt, je nachdem, ob das Abdeckelement einen Totpunkt in der einen Bewegungsrichtung oder in der anderen überschreitet. An wenigstens einem Punkt der Förderstrecke greift die Abdeckelement-Stellvorrichtung am Abdeckelement an, dessen Flaschenhalter keine Flasche erhalten hat, um dieses über den Totpunkt in Richtung zur Abdeckstellung zu verstellen. Der Kraftspeicher bringt das Abdeckelement in die Abdeckstellung und hält es in der Abdeckstellung, bis die Abdeckelement-Rückstellvorrichtung wiederum lokal wirksam ist. Bei dieser Ausführungsform braucht entlang des überwiegenden Teils der Förderstrecke keine Führung für das Abdeckelement vorgesehen sein, das seine jeweilige Stellung selbsttätig einhält.

Zweckmäßig ist es gemäß Anspruch 13, die Abdeckelement-Stellvorrichtung nachgiebig zum Angriff zu bringen, um das Abdeckelement nur dann in die Abdeckstellung zu bringen, wenn der Flaschenhalter keine Flasche erhalten hat. Ist hingegen eine ordnungsgemäße Bestückung mit einer Flasche erfolgt, dann hindert der durch den Kontakt zwischen dem Abdeckelement und der Flasche entstehende Bewegungswiderstand die Verstellung des Abdeckelements in die Abdeckstellung, das seine Passivstellung ohne Einfluss von außen selbsttätig einhält.

Bei einer weiteren alternativen Ausführungsform gemäß Anspruch 14 kann ein in einer Richtung oder in beiden Richtungen wirksamer Antrieb für das Abdeckelement am Transportkörper vorgesehen sein, der je nachdem aktiviert wird, ob eine Flasche ordnungsgemäß am Flaschenhalter angebracht wurde, oder nicht. Die jeweilige Betätigung wird abgeleitet von der Funktion des Flaschenabtasters. Dabei kann der Flaschenabtaster nicht nur mechanisch arbeiten, sondern auch berührungslos auf optischem, pneumatischem oder induktivem Weg, um die notwendigen Antriebssignale für den Antrieb zu erzeugen. Als Antrieb können Schaltmagneten oder Permanentmagneten und/oder ein Hydraulik- oder Druckluftzylinder verwendet werden. Ist der Antrieb bistabil ausgelegt, dann reicht jeweils ein kurzer Antriebsimpuls nach der Flaschenübernahme bzw. vor der Flaschenabgabe, um das Abdeckelement in die richtige Stellung zu verstellen.

Anhand der Zeichnung werden Ausfuhrungsformen des Erfindungsgegenstandes erläutert. Es zeigen:
- Fig. 1: eine schematische Draufsicht auf eine Vorrichtung zum Beschichten von Flaschen,
- Fig. 2: eine Achsschnittdarstellung eines Teils der Vorrichtung von Fig. 1, insbesondere eines Transportkörpers, etwa an der Position X in Fig. 1,
- Fig. 3: eine ähnliche Schnittdarstellung wie in Fig. 2 an einer Position Y in der Vorrichtung von Fig. 1, und
- Fig. 4: schematisch eine Stirnansicht eines Transportkörpers einer anderen Ausführungsform.

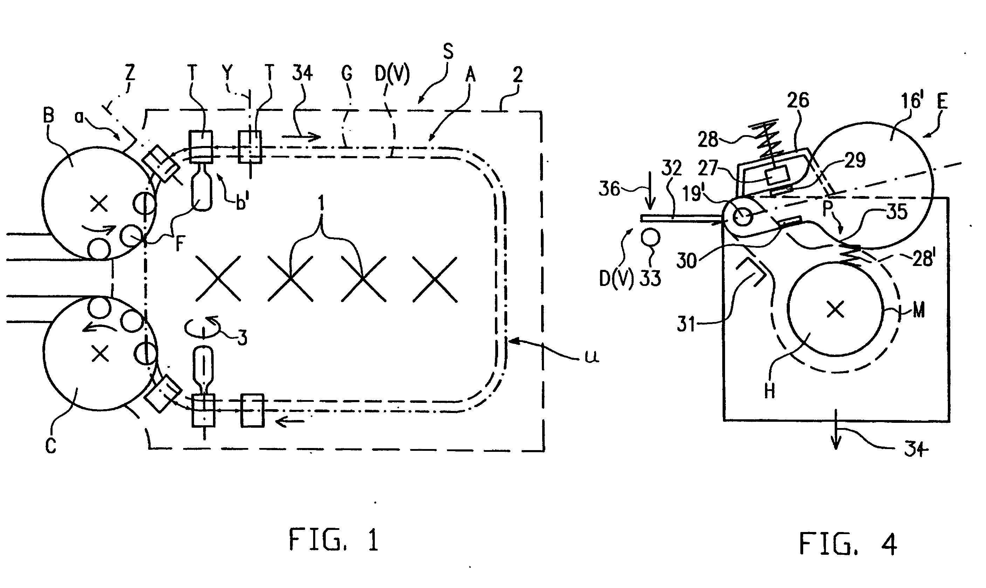

Eine in Fig. 1 schematisch gezeigte Vorrichtung S zum Beschichten von Flaschen F, insbesondere Kunststoffflaschen wie PET-Flaschen in der Getränkeindustrie, besteht aus einer Beschichtungsstation A mit unten bzw. innenliegenden Beschichtungseinrichtungen 1, beispielsweise in Form von Verdampfern, einem zugeordneten Flaschen-Übergabestern B, einem Flaschenabnahmestern C und einer diese Komponenten verbindenden Förderstrecke G. Entlang der Förderstrecke G werden aufeinanderfolgend Transportkörper T durch nicht gezeigte Antriebseinrichtungen bewegt. In einem Übergabebereich a sind die Flaschen F im wesentlichen mit ihrer Längsachse vertikal orientiert, während sie in der Beschichtungsstation A wie bei b angedeutet, im wesentlichen horizontal orientiert sind. Die hierfür erforderlichen Lageänderungen werden zweckmäßigerweise durch die Förderstrecke G vorgenommen. Beim Durchlauf durch die Beschichtungsstation A wird jede Flasche F um ihre Längsachse in Richtung eines Pfeils 3 rotiert und dabei beschichtet. Die Beschichtungsstation A ist in einem gestrichelt angedeuteten Gehäuse 2 enthalten und gegebenenfalls mit Unterdruck beaufschlagt. Gestrichelt ist ferner eine Abdeckelement-Stellvorrichtung V angedeutet, die als stationäre Führung D parallel zur und zweckmäßigerweise an der Förderstrecke G vorgesehen ist.

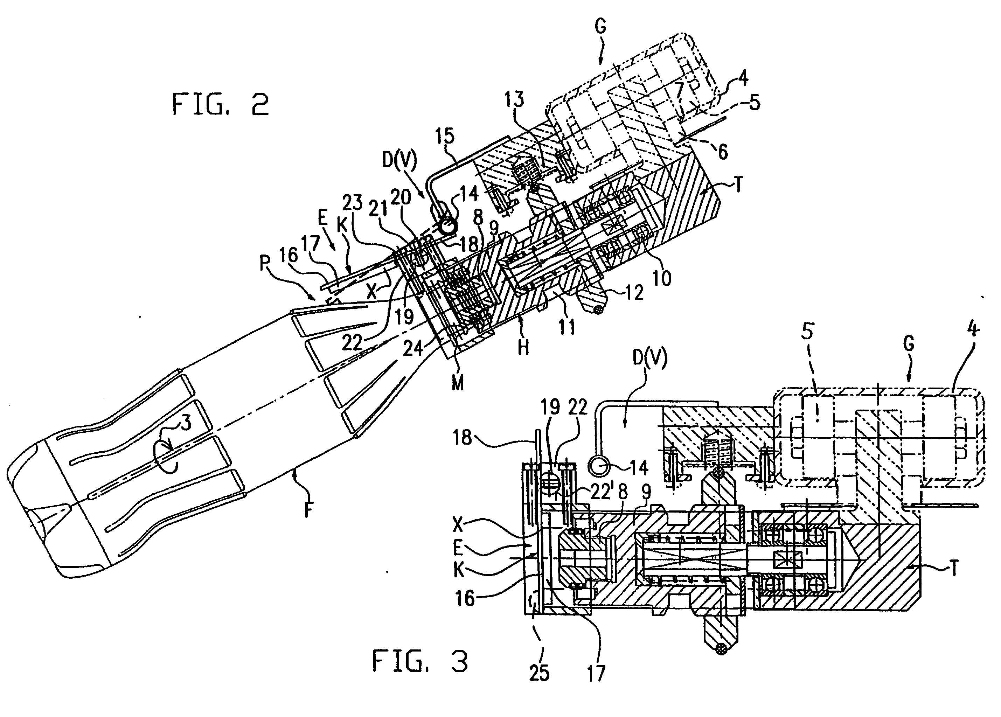

Gemäß Fig. 2 ist jeder Transportkörper T mit einem beweglich gelagerten Abdeckelement E ausgestattet, dessen Aufgabe es ist, einen im Transportkörper T enthaltenen Flaschenhalter H dann gegen die Beschichtungssubstanzen abzudecken, wenn der Flaschenhalter nicht ordnungsgemäß mit einer Flasche F (wie der Transportkörper T in Fig. 3) bestückt worden ist. Dieser Umstand kann zufolge einer Störung bei der Flaschenübernahme unkontrolliert auftreten, oder am Ende eines Beschichtungszyklus. Wäre dann der Flaschenhalter H nicht abgedeckt, dann würden die Beschichtungssubstanzen zu die weitere Funktion des Flaschenhalters H beeinträchtigenden Verschmutzungen und Ablagerungen führen.

Die Förderstrecke G in den Fig. 2 und 3 weist bei der gezeigten Ausführungsform ein C-Profil 4 mit innenliegenden Laufbahnen für Führungsrollen 5 und einen Führungsschlitz 7 für ein an jedem Transportkörper T angebrachtes Führungsglied 6 auf. Der Transportkörper T ist von blockförmiger Gestalt und lagert den beweglichen Flaschenhalter H. Der Flaschenhalter H weist einen Haltedorn 8 für eine Flaschenmündung 24 und einen Tragteil 9 auf, der in einer Drehlagerung 10 um die Längsachse der Flasche F in Richtung des Pfeils 3 drehbar gelagert ist. Das freie Ende des Tragteils 9 und des Haltedorns 8 sind in einer Mündungsöffnung M des Transportkörpers T in Richtung der Flaschenachse verschiebbar. Eine Umfangsnut 11 dient zum Angriff eines nicht dargestellten Verstellmechanismus, der den Tragteil 9 mit dem Haltedorn 8 gegen Federkraft in axialer Richtung verstellt. Am Tragteil 9 ist ein Reibrad 12 befestigt, das an einer an dem C-Profil 4 angebrachten Laufbahn 13 läuft und bei der in etwa senkrecht zur Zeichenebene stattfindenden Förderbewegung des Transportkörpers T die Rotationsbewegung für die Flasche F ableitet.

Bei der Ausführungsform in Fig. 2 und 3 ist die stationäre Führung D in Form eines Rundprofils 14 an der Laufbahn 13 gehaltert, zweckmäßigerweise in regelmäßigen Abständen über Haltearme 15. Gestrichelt ist angedeutet, dass der Beginn des Rundprofils 14 etwas nach oben gebogen ist, um mit dem am Transportkörper T über eine Schwenkachse 19 gelagerten Abdeckelement E auf eine bestimmte Weise zusammenzuarbeiten.

Das Abdeckelement E ist eine durch eine Blech- oder Kunststoffplatte gebildete, im wesentlichen ebene Klappe K, die z.B. aus einem kürzeren Verstellteil 18 und einem längeren Abdeckteil 16 besteht. Alternativ könnte der Abdeckteil 16 auch mit größerer Masse ausgebildet werden. In jedem Fall ist der mit X angedeutete Massenschwerpunkt des Abdeckelements E so weit von seiner Schwenkachse 19 entfernt, dass die Schwerkraft das Abdeckelement zwischen der in Fig. 2 gezeigten Passivstellung und der in Fig. 3 gezeigten Abdeckstellung hin- und herzuverstellen vermag, und das Abdeckelement E auch in der jeweiligen Stellung hält.

Die Schwenkachse 19 besitzt eine Abflachung 20 und ist an der Unterseite der Klappe K mit Schrauben 21 befestigt. Seitlich über die Klappe K (zumindest an einer Seite) vorstehende Achsstummel der Schwenkachse 19 greifen in Lagerbohrungen 22' von Lagerböcken 22 ein, die mit Schrauben 23 am Transportkörper T seitlich neben der Mündungsöffnung M befestigt sind. Zweckmäßigerweise bestehen die Lagerböcke 22 aus gleitfreudigem Kunststoff, z.B. Teflon und/oder sind die Achsstummel gleitfreudig beschichtet oder aus gleitfreudigem Material gebildet.

Zusätzlich kann an der Unterseite des Abdeckteils 16 ein Verschlussteil 17 vorgesehen sein, das in der in Fig. 3 gezeigten Abdeckstellung in die Mündungsöffnung M eintritt oder an dieser anliegt. Gegebenenfalls ist ferner (gestrichelt in Fig. 3 angedeutet) ein Ballastgewicht 25 am Abdeckelement E vorgesehen, um den Massenschwerpunkt X möglichst weit von der Schwenkachse 19 zu beabstanden und/oder einen kräftigen Stellimpuls unter Schwerkrafteinfluss zu erzeugen.

In Fig. 2 ist ferner angedeutet, dass das Abdeckelement E selbst als Flaschenabtaster P fungiert, der für die wirkungsmäßige Zusammenarbeit zwischen dem Abdeckelement E und der Abdeckelement-Stellvorrichtung V sorgt. Die Führung D der Stellvorrichtung V erstreckt sich gemäß Fig. 1 in Förderrichtung (Pfeil 34) von ihrem Beginn nach dem Übergabebereich a entlang der Förderstrecke G bis knapp vor den Abnahmebereich beim Abnahmestern C. Sie dient ausschließlich dazu, das Abdeckelement in der in Fig. 2 in ausgezogenen Linien gezeigten Passivstellung zu halten, in der das Abdeckelement E keinen Kontakt mit der sich drehenden Flasche F hat. Die jeweilige Verstellung des Abdeckelements E wird durch Lageänderungen des Transportkörpers T vorgenommen.

### Funktion:

Bei der Überlappung jedes Transportkörpers T mit dem Übergabestern B ist der Flaschenhalter H annähernd vertikal orientiert, wie auch die ankommenden Flaschen F. Eine Flasche F wird durch einen nicht gezeigten Übergabemechanismus und durch axiales Verstellen des Tragteils 9 mit ihrer Flaschenmündung 24 mit dem Haltedorn 8 verrastet. Anschließend an den Übergabebereich a wird der Transportkörper T durch die Förderstrecke G bzw. eine entsprechende Verwindung des C-Profils 4 allmählich bis in eine annähernd horizontale Lage um die Transportrichtung verdreht. Im Übergabebereich a wird das Abdeckelement E selbsttätig durch die Schwerkraft in der Passivstellung gemäß Fig. 2 hängend gehalten. In der Position Z ist der Transportkörper T bereits in eine Schräglage gebracht worden. Durch diese Lageänderung wird das Abdeckelement E unter der Schwerkraft zum Kontakt mit der Flasche F gebracht, so dass der Verstellteil 18 die gestrichelte Position einnimmt, in der er gegen den Anfang (gestrichelt gezeigt) des Rundprofils 14 anläuft und bei der fortlaufenden Bewegung des Transportkörpers T schließlich (ausgezogen gezeigt) voll in die Passivstellung gedrückt wird. In dieser Passivstellung bleibt das Abdeckelement während des Durchlaufs durch die Beschichtungsstation A. Erst unmittelbar vor der Abnahme beim Abnahmestern C hört der Eingriff des Rundprofils 14 auf. Da dann der Transportkörper T bereits wieder weitestgehend in die vertikale Lage gebracht worden ist, hängt das Abdeckelement E unter der Einwirkung der Schwerkraft selbsttätig wieder in der Passivstellung, so dass die Abnahme der beschichteten Flasche F problemlos möglich und die Mündungsöffnung M für die darauffolgende Übernahme einer neuen Flasche F frei zugänglich ist.

Sollte aus irgendwelchen Gründen keine Flasche am Flaschenhalter H angebracht worden sein (Fig. 3), dann ist an der Position Z das Abdeckelement E unter dem Einfluss der Schwerkraft bereits so weit mit der Schwenkachse 9 entgegen dem Uhrzeigersinn verschwenkt, dass der Verstellteil 18 am Beginn des Rundprofils 14 außen vorbei läuft und vom Rundprofil 14 bzw. der Führung D nicht ergriffen werden kann. Vielmehr senkt sich das Abdeckelement unter dem Einfluss der Schwerkraft beim zunehmenden Hochdrehen des Transportkörpers T in der Sprühstation A schließlich bis in die in Fig. 3 gezeigte Abdeckstellung, die es an der Position Y in Fig. 1 längst eingenommen hat. Die Mündungsöffnung M ist verschlossen. Der Haltedorn 8 und das freie Ende des Tragteils 9 sind gegen die Beschichtungssubstanzen geschützt. Nähert sich dieser Transportkörper später dem Abnahmestern C, dann wird durch Senkrechtstellen des Flaschenhalters H das Abdeckelement E selbsttätig durch die Schwerkraft wieder in die in Fig. 2 in ausgezogenen Linien gezeigte Passivstellung zurückverstellt.

Bei der alternativen Ausführungsform des Transportkörpers T in Fig. 4 ist das Abdeckelement E eine im Umriss beispielsweise birnenförmige Klappe, die blendenartig zwischen der in ausgezogenen Linien gezeigten Passivstellung und der in gestrichelten Linien gezeigten Abdeckstellung um die Schwenkachse 19' hin- und herschwenkbar ist. In dieser Ausführungsform ist die Schwenkachse 19' annähernd parallel zur Flaschenachse. Der Transportkörper T bewegt sich in Richtung des Pfeiles 34 entlang der Förderstrecke.

Am Transportkörper T ist in einer Halterung 26 ein Kraftspeicher 27, beispielsweise ein Permanentmagnet oder dgl., gehalten, der mit einem Gegenelement 29 am Abdeckteil 16' des Abdeckelements E, z.B. magnetisch, zusammenwirkt. Ein weiterer Kraftspeicher, z.B. ein Permanentmagnet 31, ist auf eine weiteres Gegenelement 30 ausgerichtet. Der Kraftspeicher 27 dient zum Beaufschlagen des Abdeckelements E in Richtung zur Passivstellung. Der Kraftspeicher 31 dient hingegen zum Beaufschlagen und Halten des Abdeckelements E in Richtung zur und in der Abdeckstellung. Zusätzlich kann eine Feder 28 vorgesehen sein, die eine gefederte Nachziehbewegung des Kraftspeichers 27 in Richtung zur Abdeckstellung zulässt, oder alternativ eine Feder 28', die im Bereich des Randabschnittes 35 des Abdeckteils 16 vorgesehen ist, der als Flaschenabtaster P fungiert.

Ein federnd nachgiebiger Arm 32 des Abdeckelements E ragt vom Transportkörper nach außen vor. Ein stationärer Anschlag 33 bildet die Abdeckelement-Stellvorrichtung V bzw. die -führung D.

Zunächst befindet sich das Abdeckelement E in der in ausgezogenen Linien gezeichneten Passivstellung. Bei der Bewegung des Transportkörpers T in Richtung des Pfeiles 34 läuft der Arm 32 gegen den Anschlag 33. Dadurch wird der Haltewiderstand des Kraftspeichers 27 überwunden oder der Kraftspeicher gegen die Kraft der Feder 28 ein Stück mitbewegt, bis schließlich das Abdeckelement E bei ordnungsgemäßer Bestückung des Flaschenhalters mit einer Flasche auf diese Flasche trifft. Unter dem dann ansteigenden Bewegungswiderstand des Abdeckelementes E wird der Arm 32 gebogen, bis er schließlich über den Anschlag 33 schnappt, worauf das Abdeckelement E selbsttätig wieder in die Passivstellung zurückkehrt und diese einhält.

Sollte hingegen keine Flasche in die Mündungsöffnung M eingebracht worden sein, dann trennt der Anschlag 33 über den Arm 32 das Abdeckelement mit seinem Gegenelement 29 vom Kraftspeicher 27, worauf das Abdeckelement E bis in die Abdeckstellung verschwenkt und die Mündungsöffnung M verschließt. Der Anschlag 33 schnappt über das Ende des Arms 32. Der Kraftspeicher 31 hält das Abdeckelement E in der Abdeckstellung. Bei entsprechender Auslegung der Schwenklagerung des Abdeckelementes E könnte der Kraftspeicher 31 auch weggelassen werden, so dass das Abdeckelement unter dem Einfluss der Schwerkraft und/oder Reibungskraft die Abdeckstellung selbsttätig einhält.

Kurz bevor der Transportkörper T in den Abnahmestern C gelangt, greift eine Rückstellvorrichtung 36 am Arm 32 an, um das Abdeckelement E wieder in die Passivstellung zurückzustellen.

Bei einer weiteren, nicht gezeigten alternativen Ausführungsform kann am Transportkörper T ein Antrieb, beispielsweise mit Schaltmagneten und/oder Hydraulik- oder Pneumatikzylindern vorgesehen sein, um das Abdeckelement zwischen seinen beiden Stellungen hin- und herzuverstellen. Der Antrieb wird jeweils aktiviert durch den Flaschenabtaster, der auf optischem, pneumatischem oder anderem Weg feststellt, ob ordnungsgemäß eine Flasche am Flaschenhalter angebracht worden ist, oder nicht, und entsprechend der jeweiligen Kondition einen an den Antrieb zu übertragenden Antriebsimpuls auslöst. Vor Eintreten des Transportkörpers T in den Abnahmestern wird ein entgegengesetzter Antriebsimpuls übertragen.

Der Vorzug ist jedoch einer Lösung zu geben, die weitestgehend unabhängig von Antriebselementen nur durch Schwerkraft arbeitet und Lageänderungen des Transportkörpers entlang der Förderstrecke zum Verstellen des direkt am Transportkörper angeordneten und von diesem durch die Sprühstation transportierten Abdeckelements nutzt. Da eine solche Lösung keine nennenswerten Modifikationen an bewährten Beschichtungsvorrichtungen bzw. Transportkörpern bedingt, lassen sich auch schon im Betrieb befindliche Transportkörper entsprechend nachrüsten.

Bei der Ausführung nach Fig. 1 bis 3 ist es möglich, die Transportkörper T in dem von den Übergabesternen B und C abgewandten Umlenkbereich U der Förderstrecke G vorübergehend senkrecht zu stellen, um auch bei einer dichten Anordnung der Flaschen F eine problemlose Umlenkung zu realisieren. Die stationäre Führung D kann dann entweder der Schwenkung der Transportkörper T folgend angeordnet sein oder im Umlenkbereich U auch vollständig entfallen, da hier keine Flaschenrotation stattfindet. Eine vorübergehende Senkrechtstellung der Transportkörper T im Umlenkbereich U führt zu einer vorübergehenden Öffnung der Abdeckelemente E aufgrund der Schwerkraft bei flaschenlosen Transportkörpern T. Dies hat aufgrund der großen Entfernung von den Beschichtungseinrichtungen 1 jedoch keine nachteiligen Auswirkungen. Außerdem haben die Abdeckelemente E auch bei senkrechter Lage der Transportkörper T eine gewisse Abschirmwirkung, da sie an der zu den Beschichtungseinrichtungen 1 weisenden Seite der Transportkörper T gelagert sind, die bei horizontaler Lage der Transportkörper oben liegt. Erforderlichenfalls können die Abdeckelemente E im Umlenkbereich U auch durch eine zusätzliche stationäre Führung geschlossen gehalten werden.

## Patentansprüche

1. Vorrichtung zum Beschichten von Flaschen, insbesondere von aus Kunststoff bestehenden Getränkeflaschen, mit einer zumindest einen Abschnitt einer Förderstrecke (G) für Flaschen-Transportkörper (T) enthaltenden Beschichtungsstation (A), mit einem Flaschenhalter (H) in jedem Transportkörper, mit den Transpprtkörpern (T) zugeordneten, jeweils zwischen einer Passivstellung und einer Abdeckstellung verstellbaren Flaschenhalter-Abdeckelementen (E), und mit einem die An- oder Abwesenheit einer Flasche (F) am Flaschenhalter (H) detektierenden, mit einer Abdeckelement-Stellvorrichtung (V) kooperierenden Flaschenabtaster (P), **dadurch gekennzeichnet, dass** die Abdeckelemente (E) in Ausrichtung auf die Flaschenhalter (H) direkt an den Transportkörpern (T) angeordnet sind.

2. Vorrichtung nach Anspruch 1, **dadurch gekennzeichnet, dass** das Abdeckelement (E) in einer Schwenk- oder Drehlagerung am Transportkörper (T) abgestützt ist, dass der Massenschwerpunkt (X) des Abdeckelements (E) von der Schwenk- oder Drehlagerung beabstandet ist, und dass die Schwenk- oder Drehlagerung und der Massenschwerpunkt in Bezug auf den Flaschenhalter (H) derart angeordnet sind, dass das Abdeckelement (E) zumindest weitestgehend selbsttätig unter der Schwerkraft zwischen den Passiv- und Abdeckstellungen verstellbar ist.

3. Vorrichtung nach Anspruch 2, **dadurch gekennzeichnet, dass** der Transportkörper (T) entlang der Förderstrecke (G) zwangsweise um die Förderrichtung verdrehbar ist, und dass das Abdeckelement (E) durch die Verdrehung des Transportkörpers unter der Schwerkraft zwischen den Passiv- und Abdeckstellungen verstellbar und jeweils in einer der Stellungen haltbar ist.

4. Vorrichtung nach Anspruch 3, **dadurch gekennzeichnet, dass** der Transportkörper (T) bei der Flaschenübernahme und -abgabe jeweils mit dem Flaschenhalter (H) in etwa vertikal und in der Beschichtungsstation (A) in etwa horizontal orientiert ist.

5. Vorrichtung nach Anspruch 2, **dadurch gekennzeichnet, dass** der Flaschenhalter (H) einen in einer Mündungsöffnung (M) des Transportkörpers (T) beweglichen Haltedorn (8) aufweist, und dass am Abdeckelement (E) ein in oder auf die Mundungsöffnung (M) passendes Verschlussteil (17) vorgesehen ist.

6. Vorrichtung nach Anspruch 2, **dadurch gekennzeichnet, dass** das Abdeckelement (E) eine Klappe (K) ist, die um eine an einer Seite des Flaschenhalters (H) am Transportkörper (T) angeordnete Schwenkachse (19) schwenkbar ist, vorzugsweise um mindestens 90°.

7. Vorrichtung nach Anspruch 6, **dadurch gekennzeichnet, dass** die Klappe (K) eine Blech- oder Kunststoffplatte ist, dass die Schwenkachse (19) mit einer Abflachung (20) an der Klappe befestigt ist und beidendig über die Klappe vorstehende Achsstummel aufweist, die in Lagerbohrungen (22') am Transportkörper (T) befestigter Lagerböcke (22) eingreifen, und dass die Schwenkachse (19) an der Klappe zwischen einem kürzeren Verstellteil (18) und einem längeren Abdeckteil (16) angeordnet ist.

8. Vorrichtung nach Anspruch 7, **dadurch gekennzeichnet, dass** zumindest die Lagerbohrungen (22') in den Lagerböcken (22) aus gleitfreudigem Kunststoff bestehen, und/oder die Achsstummel mit gleitfreudigen Beschichtungen versehen sind.

9. Vorrichtung nach Anspruch 6, **dadurch gekennzeichnet, dass** die Klappe (K) ein den Abstand des Massenschwerpunkts (X) von der Schwenkachse (19) vergrößerndes Ballastgewicht (25) trägt.

10. Vorrichtung nach Anspruch 1, **dadurch gekennzeichnet, dass** die Abdeckelement-Stellvorrichtung (V) eine entlang zumindest eines Abschnitts der Förderstrecke (G) verlaufende, stationäre Führung (D) ist, an der zum Halten der Klappe (K) in der Passivstellung der Verstellteil (18) der Klappe (K) abhängig davon zum Angriff bringbar ist, dass am Beginn der Führung (D) eine ordnungsgemäß am Flaschenhalter (H) angebrachte Flasche (F) die Klappe (K) bereits im wesentlichen in der Passivstellung hält.

11. Vorrichtung nach Anspruch 1, **dadurch gekennzeichnet, dass** das Abdeckelement (E) durch einen Kraftspeicher (27, 31) zumindest in Richtung zur Abdeckstellung beaufschlagbar ist, und dass die Abdeckelement-Stellvorrichtung (V) eine zumindest entlang eines Abschnitts der Förderstrecke (G) verlaufende, stationäre Führung (D) ist, die zum Halten des Abdeckelements in der Passivstellung abhängig davon am Abdeckelement zum Angriff bringbar ist, dass am Beginn der Führung (D) eine ordnungsgemäß am Flaschenhalter (H) angebrachte Flasche (F) das Abdeckelement (E) bereits im wesentlichen in der Passivstellung hält.

12. Vorrichtung nach Anspruch 1, **dadurch gekennzeichnet, dass** das Abdeckelement (E) durch Kraftspeicher (27, 31) bistabil in die Passivstellung und in die Abdeckstellung vorspannbar ist, und dass die Abdeckelement-Stellvorrichtung (V) lokal an wenigstens einem Punkt der Förderstrecke (G) jedes in der Passivstellung befindliche Abdeckelement (E) in die Abdeckstellung verstellt, dessen zugeordneter Flaschenhalter (H) keine Flasche (F) übernommen hat, und dass, vorzugsweise, bei einem Endabschnitt der Förderstrecke (G) eine weitere, lokale Abdeckelement-Rückstellvorrichtung (36) für alle in der Abdeckstellung befindliche Abdeckelemente (E) vorgesehen ist.

13. Vorrichtung nach Anspruch 12, **dadurch gekennzeichnet, dass** die Abdeckelement-Stellvorrichtung (V) nachgiebig mit einer Stellkraft am Abdeckelement (E) zum Angriff bringbar ist, die größer als die Kraftspeicher-Vorspannung, jedoch kleiner ist als der bei Vorliegen einer Flasche (F) am Flaschenhalter (H) auftretende Bewegungswiderstand des an der Flasche (F) anliegenden Abdeckelements (E).

14. Vorrichtung nach Anspruch 1, **dadurch gekennzeichnet, dass** das Abdeckelement (E) durch einen Antrieb mit wenigstens einem Schaltmagneten oder einem Hydraulik- oder Druckluftzylinder verstellbar ist, und dass der Antrieb wirkungsmäßig mit dem Flaschenabtaster (P) verknüpft ist.

15. Flaschen-Transportkörper (T) einer Vorrichtung zum Beschichten von Flaschen (F), mit einem Flaschenhalter und an einer Förderstrecke (G) zum Angriff bringbaren Fördergliedern (5, 6), **dadurch gekennzeichnet, dass** am Transportkörper (T) direkt ein relativ zum Flaschenhalter (H) zwischen einer Passivstellung und einer Abdeckstellung bewegbares Abdeckelement (E) vorgesehen ist, und dass das Abdeckelement (E) durch förderstreckenbedingte Lageänderungen des Transportkörpers (T) selbsttätig unter dem Einfluss der Schwerkraft zwischen den Stellungen hin- und herbewegbar ist.

## Claims

1. Apparatus for coating bottles, in particular plastic beverage bottles, said apparatus comprising a coating station (A) including at least one section of a conveyor track (G) for bottle-transporting elements (T); a bottle-holder (H) in each transporting element; bottle-holder covering elements (E) associated with the transporting elements (T), each of said bottle-holder covering elements being movable between a passive position and a covering position; and a bottle sensor (P) which detects the presence or absence of a bottle (F) on the bottle-holder (H) and cooperates with a covering-element control device (V), **characterized in that** the covering elements (E) are disposed directly on the transporting elements (T) in such a way as to be in alignment with the bottle-holders (H).

2. Apparatus according to Claim 1, **characterized in that** the covering element (E) is supported in a swivel or pivot bearing on the transporting element (T), **in that** the mass centre (X) of the covering element (E) is at a distance from the swivel or pivot bearing, and **in that** the swivel or pivot bearing and the mass centre are disposed in such a way relative to the bottle-holder (H) that, at least to a large extent, the covering element (E) can be moved automatically under the force of gravity between the passive and covering positions.

3. Apparatus according to Claim 2, **characterized in that** the transporting element (T) can twist along the conveyor track (G) in a controlled manner about the direction of transport, and **in that,** due to the twisting movement of the transporting element, the covering element (E) can be moved under the force of gravity between the passive and covering positions and in each case can be held in one of the positions.

4. Apparatus according to Claim 3, **characterized in that** the transporting element (T) with the respective bottle-holder (H) is oriented more or less vertically on receiving and releasing the bottles and is oriented more or less horizontally in the coating station (A).

5. Apparatus according to Claim 2, **characterized in that** the bottle-holder (H) has a holding mandrel (8) which is movable in a mouth opening (M) of the transporting element (T), and **in that** a sealing component (17) which fits into or on the mouth opening (M) is provided on the covering element (E).

6. Apparatus according to Claim 2, **characterized in that** the covering element (E) is a flap (K), which can swivel about a swivel pin (19) disposed on the transporting element (T) on one side of the bottle-holder (H), preferably swivelling through at least 90°.

7. Apparatus according to Claim 6, **characterized in that** the flap (K) is a sheet-metal or plastic plate, **in that** the swivel pin (19) is fixed to a flat area (20) on the flap and has journals which project beyond the flap at both ends, said journals engaging in bearing bores (22') in bearing blocks (22) fixed to the transporting element (T), and **in that** the swivel pin (19) is disposed on the flap between a shorter adjusting component (18) and a longer covering component (16).

8. Apparatus according to Claim 7, **characterized in that** at least the bearing bores (22') in the bearing blocks (22) are made of glide-promoting plastic material, and/or the journals are provided with glide-promoting coatings.

9. Apparatus according to Claim 6, **characterized in that** the flap (K) bears a ballast weight (25) which increases the distance between the mass centre (X) and the swivel pin (19).

10. Apparatus according to Claim 1, **characterized in that** the covering-element control device (V) is a stationary guide (D) running along at least one section of the conveyor track (G), the adjusting component (18) of the flap (K) being engageable with said guide (D) so as to hold the flap (K) in the passive position provided that, at the beginning of the guide (D), a bottle (F), properly fitted on to the bottle-holder (H), is already holding the flap (K) substantially in the passive position.

11. Apparatus according to Claim 1, **characterized in that** the covering element (E) can be urged by an energy storing device (27, 31) at least in the direction of the covering position, and **in that** the covering-element control device (V) is a stationary guide (D) which runs at least along one section of the conveyor track (G), said guide (D) being engageable with the covering element so as to hold the covering element in the passive position, provided that, at the beginning of the guide (D), a bottle (F), properly fitted on to the bottle-holder (H), is already holding the covering element (E) substantially in the passive position.

12. Apparatus according to Claim 1, **characterized in that** the covering element (E) can be bistably biased by energy storing devices (27, 31) into the passive position and into the covering position, and **in that,** at least at one point of the conveyor track (G), the covering-element control device (V) locally moves any covering element (E) disposed in the passive position, whose associated bottle-holder (H) has not received a bottle (F), into the covering position, and **in that**, preferably, at one end section of the conveyor track (G) an additional, local covering-element resetting device (36) is provided for all covering elements (E) disposed in the covering position.

13. Apparatus according to Claim 12, **characterized in that** the covering-element control device (V) is flexibly engageable with the covering element (E), with an adjusting force which is greater than the biasing of the energy storing device but is less than the kinetic resistance of the covering element (E) resting against the bottle (F), such as occurs in the presence of a bottle (F) on the bottle-holder (H).

14. Apparatus according to Claim 1, **characterized in that** the covering element (E) can be moved by a drive unit having at least one switching magnet or a hydraulic or compressed-air cylinder, and **in that** the drive unit is operatively linked with the bottle sensor (P).

15. Bottle-transporting element (T) of an apparatus for coating bottles (F), comprising a bottle-holder and conveying members (5, 6) which are engageable with a conveyor track (G), **characterized in that** a covering element (E) is provided directly on the transporting element (T), said covering element (E) being movable relative to the bottle-holder (H) between a passive position and a covering position, and **in that** the covering element (E) can be automatically moved to and fro under the influence of gravity between said positions by conveyor-track-related changes of position of the transporting element (T).

## Revendications

1. Dispositif pour enduire des bouteilles, notamment des bouteilles à boisson en matière plastique, comprenant un poste d'enduction (A) avec au moins un segment de chemin de transport (G) pour l'organe transporteur de bouteilles (T), un support de bouteilles (H) dans chaque organe de transport, des éléments de recouvrement de support de bouteilles (E) associés aux organes de transport (T), et mobiles entre une position passive et une position de recouvrement, ainsi qu'un détecteur de bouteilles (P) détectant la présence ou l'absence d'une bouteille (F) dans le support de bouteilles (H), et coopérant avec un dispositif d'actionnement (V) de l'élément de recouvrement,
**caractérisé en ce que**
les éléments de recouvrement (E) sont installés directement sur les organes de transport (T), dans la direction d'alignement des supports de bouteilles (H).

2. Dispositif selon la revendication 1,
**caractérisé en ce que**
l'élément de recouvrement (E) est supporté par l'organe de transport (T) par un palier de pivotement ou de rotation,
le centre de gravité (X) de l'élément de recouvrement (E) est distant du palier de rotation ou de pivotement et
le palier de rotation ou de pivotement et le centre de gravité sont disposés par rapport au support de bouteilles (H) de façon que l'élément de recouvrement (E) puisse être actionné au moins en grande partie automatiquement sous l'effet du poids entre la position passive et la position de recouvrement.

3. Dispositif selon la revendication 2,
**caractérisé en ce que**
l'organe de transport (T) peut tourner de force le long du chemin de transfert (H), autour du dispositif de transfert et
l'élément de recouvrement (E) est réglable par la rotation de l'organe de transport sous l'effet du poids entre la position passive et la position de recouvrement et il peut être tenu chaque fois dans l'une de ces positions.

4. Dispositif selon la revendication 3,
**caractérisé en ce que**
l'organe de transport (T) est orienté sensiblement verticalement lors du transfert (réception et émission) de bouteilles avec le support de bouteilles (H), et sensiblement horizontalement dans le poste d'enduction (A).

5. Dispositif selon la revendication 2,
**caractérisé en ce que**
le support de bouteilles (H) comporte une broche de fixation (8) mobile dans l'embouchure (M) de l'organe de transport (T) et
l'élément de recouvrement (E) comporte une pièce d'obturation (17) adaptée dans ou sur l'orifice d'embouchure (M).

6. Dispositif selon la revendication 2,
**caractérisé en ce que**
l'élément de recouvrement (E) est un volet (K) qui peut pivoter autour d'un axe de pivotement (19) prévu sur un côté du support de bouteilles (H) de l'organe de transport (T), de préférence d'au moins 90°.

7. Dispositif selon la revendication 6,
**caractérisé en ce que**
le volet (K) est une plaque de tôle ou de matière plastique,
l'axe de pivotement (19) est fixé par une partie aplatie (20) contre le volet et aux deux extrémités il est prévu un élément d'axe dépassant du volet pénétrant dans un perçage de palier (22') correspondant de bloc de palier (22) fixé à l'organe de transport (T) et l'axe de pivotement (19) est prévu sur le volet, entre une pièce de réglage courte (18) et une pièce de recouvrement (16) plus longue.

8. Dispositif selon la revendication 7,
**caractérisé en ce qu'**
au moins les perçages de palier (22') des blocs paliers (22) sont en une matière plastique ayant des caractéristiques de glissement et/ou les éléments d'axe sont munis de revêtement lisse.

9. Dispositif selon la revendication 6,
**caractérisé en ce que**
le volet (K) porte un contrepoids (25) augmentant la distance entre le centre de gravité (X) et l'axe de pivotement (19).

10. Dispositif selon la revendication 1,
**caractérisé en ce que**
le dispositif de réglage de l'élément de recouvrement (V) est un guidage fixe (D) passant le long d'au moins un segment du chemin de transfert (G), et sur lequel peut venir en prise la pièce de réglage (18) du volet (K), pour tenir le volet (K) en position passive, en fonction du fait qu'au début du moyen de guidage (D), une bouteille (F), placée correctement dans le support de bouteilles (H), maintienne le volet (K) déjà pratiquement en position passive.

11. Dispositif selon la revendication 1,
**caractérisé en ce que**
l'élément de recouvrement (E) peut être sollicité par un accumulateur de force (27, 31) au moins en direction de la position de recouvrement et
le dispositif d'actionnement (V) de l'élément de recouvrement est un guidage fixe (D) dirigé au moins le long d'un segment du chemin de transfert (G), ce moyen de guidage pouvant être mis en position passive pour tenir l'élément de recouvrement, en fonction de l'élément de recouvrement par rapport au point d'attaque, pour qu'au début du guidage (D), une bouteille (F), prévue correctement dans le support de bouteilles (H), maintienne l'élément de recouvrement (E) déjà essentiellement en position passive.

12. Dispositif selon la revendication 1,
**caractérisé en ce que**
l'élément de recouvrement (E) est precontraint par un accumulateur de force (27, 31) de manière bistable dans la position passive et dans la position de recouvrement et le dispositif d'actionnement de l'élément de recouvrement (V) règle en position de recouvrement localement, en au moins un point du chemin de transfert (G), chaque élément de recouvrement (E) qui se trouve dans la position passive, et dont le support de bouteilles (H), associé, n'a pas pris de bouteille (F), et de préférence d'un segment d'extrémité du chemin de transfert (G), il est prévu un autre dispositif local de rappel (36) d'éléments de recouvrement pour tous les éléments de recouvrement (E) qui se trouvent en position de recouvrement.

13. Dispositif selon la revendication 12,
**caractérisé en ce que**
le dispositif d'actionnement de l'élément de recouvrement (V) peut venir saisir de manière souple avec une force de rappel l'élément de recouvrement (E), cette force étant supérieure à la précontrainte de l'accumulateur de force mais inférieure à la résistance au mouvement de l'élément de recouvrement (E) appliqué contre la bouteille (F) qui se trouve dans le support de bouteilles (H)..

14. Dispositif selon la revendication 1,
**caractérisé en ce que**
l'élément de recouvrement (E) est actionné par un moyen d'entraînement comportant au moins un électroaimant de commutation ou un vérin hydraulique ou un vérin pneumatique et le moyen d'entraînement est combiné de manière à coopérer avec le détecteur de bouteilles (P).

15. Organe de transport de bouteilles (T) comportant un dispositif pour enduire les bouteilles (F), un support de bouteilles et des organes dè transfert (5, 6) attaquant un chemin de transfert (G),
**caractérisé en ce que**
l'organe de transport (T) comporte, directement, un élément de recouvrement (E) mobile par rapport au support de bouteilles (H), entre une position passive et une position de recouvrement, et l'élément de recouvrement (E) peut être basculé alternativement par une variation de position conditionnée par le chemin de transfert de l'organe de transport (T), automatiquement sous l'influence du poids entre les positions.
